# EUROPÄISCHE PATENTSCHRIFT

(11) **EP 3 485 544 B1**
(45) Veröffentlichungstag und Bekanntmachung des Hinweises auf die Patenterteilung: **09.09.2020**
(21) Anmeldenummer: 17742410.8
(22) Anmeldetag: 12.07.2017
(51) Int. Cl.: H01S 3/10, H01S 3/23, H01S 5/042, H01S 5/062

(54) **LASER-TAKTSIGNALGENERATOR**
LASER CLOCK SIGNAL GENERATOR
GÉNÉRATEUR DE SIGNAUX D'HORLOGE POUR LASER

(30) Priorität: 14.07.2016 DE 102016212927
(43) Veröffentlichungstag der Anmeldung: 22.05.2019
(73) Patentinhaber: TRUMPF Laser GmbH, 78713 Schramberg (DE)
(72) Erfinder: FLAIG, Rainer, 78664 Eschbronn (DE); MOOSMANN, Daniel, 78713 Schramberg (DE); STIER, Fred, 78713 Schramberg (DE); STOLZENBURG, Christian, 78464 Konstanz (DE)
(74) Vertreter: Kohler Schmid Möbus Patentanwälte
(86) Internationale Anmeldenummer: PCT/EP2017/067619
(87) Internationale Veröffentlichungsnummer: WO 2018/011304

(56) Entgegenhaltungen:
- US-A1- 2005 225 846
- US-A1- 2011 019 705
- US-A1- 2013 272 325

## Beschreibung

Die Erfindung betrifft einen Laser-Taktsignalgenerator zur Ansteuerung eines Laserstrahlerzeugers für die Erzeugung gepulster Laserstrahlung sowie ein Lasersystem mit einem solchen Laser-Taktsignalgenerator.

Die Erzeugung gepulster Laserstrahlung basiert in der Regel auf einem elektronisch erzeugten Grundtakt. Aufgrund der Lasereigenschaften unterliegt der Grundtakt genauen Timinganforderungen bezüglich Frequenz- und Phasenlage, da Schwankungen des Grundtakts zu Energieschwankungen oder Schädigungen des Lasers führen können. Eine starre Taktvorgabe ist für viele Anwendungen jedoch unzureichend. Gewünscht ist oftmals ein durch ein externes Signal angeforderter Puls, ein sogenannter Puls on Demand.

Die US 2013/272325 A1 offenbart einen Laser-Taktsignalgenerator zur Ansteuerung eines Laserstrahlerzeugers für die Erzeugung gepulster Laserstrahlung mit einem dem Laserstrahlerzeuger zuführbaren Taktsignalausgang und einem Basistaktgenerator, der ein am Taktsignalausgang ausgebbares Basistaktsignal generiert, einem Taktvorgabesignaleingang zum Anschluss eines externen Taktvorgabesignals, wobei eine Steuereinheit vorgesehen ist, die den Basistaktgenerator ansteuert, und mit einer zwischen dem Basistaktgenerator und dem Taktsignalausgang angeordneten Signalausgabeeinrichtung.

Aufgabe der vorliegenden Erfindung ist es, einen Laser-Taktsignalgenerator bereit zu stellen, mit dem die oben genannten Anforderungen erfüllt werden können.

Gelöst wird diese Aufgabe erfindungsgemäß durch einen Laser-Taktsignalgenerator zur Ansteuerung eines Laserstrahlerzeugers für die Erzeugung gepulster Laserstrahlung mit einem dem Laserstrahlerzeuger zuführbaren bzw. mit diesem verbindbaren Taktsignalausgang und einem Basistaktgenerator, der ein am Taktsignalausgang ausgebbares Basistaktsignal generiert und einem Taktsignalvorgabeeingang zur Eingabe eines externen Taktvorgabesignals, wobei eine Steuereinheit vorgesehen ist, die den Basistaktgenerator ansteuert, und mit einer zwischen dem Basistaktgenerator und dem Taktsignalausgang angeordneten Übertaktungsschutzeinrichtung. Über die Steuereinheit kann der Basistaktgenerator fein, insbesondere auf 16 Bit genau, ganz insbesondere auf 32 Bit genau, eingestellt werden, so dass ein exaktes Basistaktsignal generiert werden kann. Mit "exaktem Basistaktsignal" ist hier ein Basistaktsignal gemeint, das einen Jitter kleiner 50 ns, insbesondere kleiner 10 ns, aufweist. Um eine Schädigung des Lasers bei Übertaktung, also zu hoher Taktfrequenz, zu vermeiden, ist die Übertaktungsschutzeinrichtung vorgesehen. Dadurch kann sichergestellt werden, dass Laserpulsaufbauzeiten in einem optischen Verstärker, z.B. in einem gepumpten Faserverstärker, Cavity-Dumped oder regenerativen Verstärkersystem eingehalten werden. Die Übertaktungsschutzeinrichtung kann als sogenannte Retriggerlocksperre ausgebildet sein. Eine Retriggerlocksperre kann ausgebildet sein, ein erneutes Starten eines Pulses, ausgelöst durch ein externes Signal (Retriggern), für eine vorgegebene Dauer oder unter vorgegebenen Bedingungen zu unterbinden. Im vorliegenden Taktsignalgenerator kann die Retriggerlocksperre insbesondere ausgebildet sein, ein erneutes Starten eines Basistaktsignals ausgelöst durch ein Pulsfrequenzsignal am Eingang der Übertaktungsschutzeinrichtung für die Dauer einer vorgegebenen Mindestpulsdauer, die sich durch eine Maximalfrequenz bestimmt, zu unterbinden. Die Bedingung kann z.B. die Dauer des ausgegebenen Pulses selbst sein. Die Bedingung kann z.B. aber auch ein Zustand eines optischen Verstärkers sein, der durch die Pulse gepumpt werden soll.

Der Basistaktgenerator kann einen Ring-Akkumulator und ein diesem zugeordnetes Frequenzregister aufweisen. Durch die Steuereinheit kann das Frequenzregister beschrieben werden, das den Ring-Akkumulator steuert. Der im Frequenzregister eingestellte Datenwert kann so eingestellt werden, dass eine vorgegebene Minimalfrequenz durch das Basistaktsignal nicht unterschritten wird. Der Ring-Akkumulator kann als Schieberegister, insbesondere als eine Hintereinanderschaltung mehrerer digitaler Flipflops mit Rückführung des letzten Flipflop-Ausgangs auf den Eingang des ersten Flipflops, ausgeführt sein. Er kann mit einer Betriebsfrequenz angesteuert sein und im Takt der Betriebsfrequenz einen Akkumulatorwert erhöhen oder vermindern. Dabei ist der im Frequenzregister abgelegte Wert maßgebend für die Schritthöhe der Erhöhung bzw. Verminderung.

Der Ring-Akkumulator kann in einem Logikbaustein, insbesondere einem FPGA, realisiert sein. Beim Überlauf des Ring-Akkumulators, d.h. beim Roll-Over des Ring-Akkumulators, erfolgt vorzugsweise die Generierung einer Flanke, insbesondere steigenden Flanke, des Basistaktsignals.

Der Basistaktgenerator kann einen Synchronisationseingang zur Synchronisierung mit dem Taktvorgabesignal - gegebenenfalls nach Entprellung des Taktvorgabesignals - aufweisen. Durch das Taktvorgabesignal, das dem Synchronisationseingang zugeführt wird, kann beispielsweise ein vorzeitiger Roll-Over des Ring-Akkumulators bewirkt werden oder der Ring-Akkumulator so zurückgesetzt werden, dass eine Flanke des Basistaktsignals erzeugt wird.

Es kann eine von der Steuereinheit ansteuerbare Logikeinheit zwischen dem Taktvorgabesignaleingang und dem Basistaktgenerator, insbesondere dem Synchronisationseingang, vorgesehen sein. Insbesondere können durch die Logikeinheit mehrere Signale logisch verknüpft werden, um ein Synchronisationssignal zu erzeugen. Auch kann das Taktvorgabesignal in Abhängigkeit der logischen Verknüpfung weiterer Signale durchgeschleift und als Synchronisationssignal verwendet werden.

Eine Messeinrichtung zur Erfassung der Frequenz des Taktvorgabesignals kann vorgesehen sein. Insbesondere kann diese Messeinrichtung in der Steuereinheit integriert sein.

Eine erste Begrenzungseinrichtung zur Unterdrückung von Taktvorgabesignalen mit einer Frequenz über einer vorgegebenen Frequenz kann vorgesehen sein. Somit kann eine externe Triggerung des Basistaktgenerators verhindert werden, wenn die Frequenz des externen Taktvorgabesignals zu hoch ist. Die Begrenzungseinrichtung kann als sogenannter Sperrtimer ausgebildet sein.

Weiterhin kann eine zweite Begrenzungseinrichtung zur Unterdrückung von Taktvorgabesignalen mit einer Frequenz unter einer vorgegebenen zweiten Frequenz vorgesehen sein. Insbesondere kann der im Frequenzregister eingestellte Datenwert von der zweiten Begrenzungseinrichtung erhöht werden, um sicherzustellen, dass eine vorgegebene zweite Frequenz nicht unterschritten wird. Somit können Schädigungen des Lasers aufgrund einer Untertaktung, d.h. einer zu niedrigen Taktfrequenz, vermieden werden.

Die zweite Begrenzungseinrichtung kann daher mit dem Basistaktgenerator zur bedarfsweisen Reduzierung der Frequenz des Basistaktsignals verbunden sein. So kann nach einer ersten erfolgten Synchronisation auch mit einer niedrigeren als der durch das Frequenzregister eingestellte Taktfrequenz getaktet werden.

Weiterhin kann eine Taktstabilisierungseinrichtung vorgesehen sein. Durch die Taktstabilisierungseinheit kann die Frequenz von direkten Synchronisierungsfolgen mit zu hoher Frequenz begrenzt werden.

Der Taktsignalgenerator kann eine Überwachungseinrichtung zur Überwachung hinsichtlich des Vorliegens eines Taktvorgabesignals aufweisen. Dabei kann die Überwachungseinrichtung als sogenannte State-Maschine ausgebildet sein. Wird durch die Überwachungseinrichtung festgestellt, dass kein Taktvorgabesignal vorliegt, so kann eine Frequenzabsenkung des Basistaktsignals automatisch aufgehoben werden. Dies bedeutet, dass eine unmittelbare, automatische Basistaktübernahme bei Ausfall des externen Taktvorgabesignals erfolgen kann.

Weiterhin kann eine Überwachungseinrichtung zur Überwachung der Synchronisation des Basistaktgenerators auf das Taktvorgabesignal vorgesehen sein. Diese Überwachungseinrichtung kann in der Steuereinheit integriert sein.

Weiterhin kann eine Taktflankenentprellung vorgesehen sein. Dadurch kann eine Fehl-Triggerung vermieden werden. Die Taktflankenentprellung kann als FPGA-Filter ausgebildet sein. Mit FPGA-Filter ist hier ein digitaler Filter gemeint, der im Logikbaustein, insbesondere im FPGA, realisiert ist.

Der Taktsignalgenerator kann im Logikbaustein, insbesondere im FPGA, ausgebildet sein. Mit dem erfindungsgemäßen Taktsignalgenerator kann ein externes Taktvorgabesignal verarbeitet werden. Ein dem Laserstrahlerzeuger zuzuführendes Taktsignal kann parametriert, freigegeben und überwacht werden. Es kann eine Minimal- und Maximal-Frequenzbegrenzung erfolgen. Außerdem kann ein Synchronisierungsfenster festgelegt werden, in dem das Taktvorgabesignal frei getriggert werden kann. Dies ist vorteilhalft für Puls-on-Demand-Anwendungen.

Insbesondere kann vorgesehen sein, dass das Taktvorgabesignal durch den Taktsignalgenerator als Taktsignal ausgegeben wird, wenn es in einem vorgegebenen Frequenzbereich liegt. Weiterhin kann das generierte Basistaktsignal als Taktsignal ausgegeben werden, wenn kein Taktvorgabesignal vorhanden ist. Der Basistaktgenerator kann mit dem Taktvorgabesignal synchronisiert werden, wenn ein solches vorhanden ist.

Weitere Merkmale und Vorteile der Erfindung ergeben sich aus der nachfolgenden detaillierten Beschreibung von Ausführungsbeispielen der Erfindung, anhand der Figuren der Zeichnung, die erfindungswesentliche Einzelheiten zeigt, sowie aus den Ansprüchen. Die dort gezeigten Merkmale sind nicht notwendig maßstäblich zu verstehen und derart dargestellt, dass die erfindungsgemäßen Besonderheiten deutlich sichtbar gemacht werden können. Die verschiedenen Merkmale können je einzeln für sich oder zu mehreren in beliebigen Kombinationen bei Varianten der Erfindung verwirklicht sein.

Gelöst wird die Aufgabe auch durch ein Lasersystem aufweisend einen Laser-Taktsignalgenerator wie zuvor beschrieben. Das Lasersystem kann weiter aufweisen: einen Pulsgenerator, eine Laseranregungseinheit und einen optischen Verstärker. Die Komponenten des Lasersystems, ihr Zusammenwirken und ihre Funktion sind im Zusammenhang mit der Figurenbeschreibung genauer beschrieben.

In den schematischen Zeichnungen sind Ausführungsbeispiele der Erfindung dargestellt und in der nachfolgenden Beschreibung näher erläutert.

Es zeigen:
- Fig. 1: einen Laser-Taktsignalgenerator;
- Fig. 2: ein Lasersystem mit einem solchen Laser-Taktsignalgenerator.

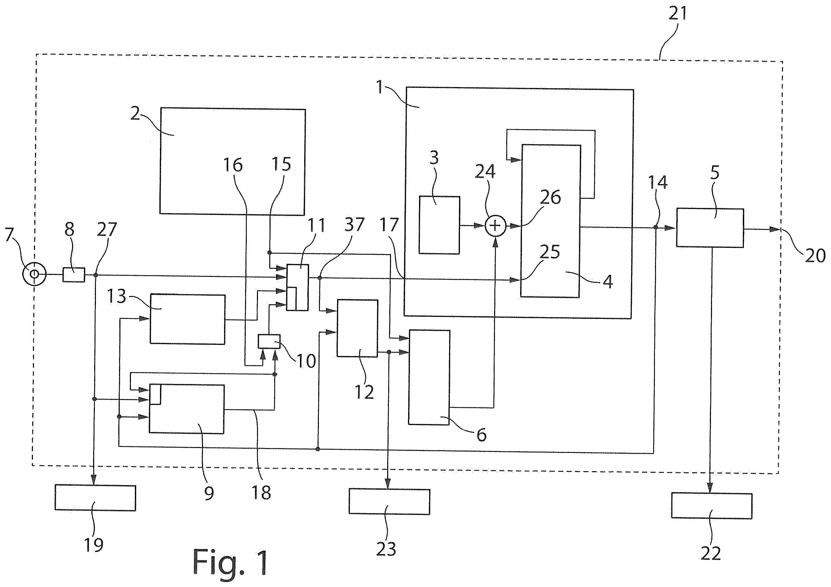

Fig. 1 zeigt einen Laser-Taktsignalgenerator 21. Dieser weist einen Basistaktgenerator 1, eine Steuereinheit 2, eine Übertaktungsschutzeinrichtung 5 und weitere Logikbausteine auf.

Der Laser-Taktsignalgenerator 21 wird mit einer Betriebsfrequenz betrieben. Die Betriebsfrequenz ist größer als 80 MHz, insbesondere größer als 150 MHz, und liegt besonders bevorzugt bei 192 MHz. Damit kann eine Jitter kleiner 10 ns erreicht werden.

Der Basistaktgenerator 1 weist einen Ring-Akkumulator 4, ein Frequenzregister 3, ein Addierglied 24 und einen Synchronisationseingang 17 auf. Das Frequenzregister 3 kann durch die Steuereinheit 2, z.B. mit einem 32-Bit-Wert, beschrieben werden. Durch das Frequenzregister 3 wird der Ring-Akkumulator 4 gesteuert. Der Ring-Akkumulator 4 wird mit der Betriebsfrequenz des Laser-Taktsignalgenerators 21 betrieben. Der Wert des Frequenzregisters 3 wird, insbesondere im Takt der Betriebsfrequenz, über das Addierglied 24 an den Ring-Akkumulator 4 gesandt. Im Addierglied 24 kann, falls notwendig, dem Wert aus dem Frequenzregister 3 noch ein Wert hinzuaddiert werden. Der so generierte Frequenzeinstellwert 26 gelangt in den Ring-Akkumulator 4. Je höher der Wert, umso höher die Frequenz, die der Ring-Akkumulator 4 erzeugt und als Pulsfrequenzsignal 14 ausgibt. Das Pulsfrequenzsignal 14 gelangt vom Ausgang des Ring-Akkumulator 4 auf den Ausgang des Basistaktgenerators 1. Vom Ausgang des Basistaktgenerators 1gelangt das Pulsfrequenzsignal 14 auf den Eingang der Übertaktungsschutzeinrichtung 5. Ein Signal, das auf den Synchronisationseingang 17 gelangt, wird auf eine Roll-Over Vorsteuerung 25 des Ring-Akkumulators 4 geführt. Das Signal vom Synchronisationseingang 17 führt zu einer Frequenz am Ausgang des Ring-Akkumulators 4, das synchron mit dem Signal vom Synchronisationseingang 17 verläuft, wenn die Frequenz des Signals vom Synchronisationseingang 17 größer oder gleich der Frequenz ist, die im Ring-Akkumulators 4 durch den Frequenzeinstellwert 26 eingestellt ist. Weist jedoch das Signal vom Synchronisationseingang 17 eine Frequenz auf, die kleiner ist als die durch den Frequenzeinstellwert 26 eingestellte Frequenz, so wird die Frequenz des Pulsfrequenzsignals 14 bestimmt durch den Frequenzeinstellwert 26.

Die Steuerung 2 weist mehrere digitale Signaleingänge und Signalausgänge auf. Sie ist im Ausführungsbeispiel auf mehrere Baugruppen verteilt dargestellt, die mit den Referenzzeichen 2, 22, 23, 19 gekennzeichnet sind, und im Folgenden näher beschrieben werden. Von mehreren Signalausgängen sind nur zwei, nämlich der eines Taktfreigabesignals 15, und eines Taktstabilisierungsfreigabesignals 16 gezeigt und ebenfalls im Folgenden näher beschrieben. Die Steuerung 2 kann Teil des Basistaktgenerators 1 sein oder extern von diesem angeordnet sein.

Der Laser-Taktsignalgenerator 21 weist ferner einen Taktvorgabesignaleingang 7 auf, über den ein externes Taktvorgabesignal eingegeben werden kann. Dieses Taktvorgabesignal gelangt zunächst zu einer Taktflankenentprellung 8. Die Taktflankenentprellung 8 kann einen Tiefpassfilter und einen Schmitt-Trigger-Baustein aufweisen, sie kann aber auch mit anderen Logikbausteinen, wie z.B. RS-Flipflop, monostabiler Kippstufe oder ähnlichen Schaltungen realisiert werden. So kann mit der Taktflankenentprellung 8 eine Fehl-Triggerung auf Grund von Störsignalen oder zu langsamem Ansteigen der Spannung beim Taktvorgabesignal vermieden werden. Die Taktflankenentprellung 8 erzeugt an ihrem Ausgang das entprellte Taktvorgabesignal 27.

Eine erste Messeinrichtung 19, die in der Steuereinheit 2 integriert sein kann, kann die Frequenz des entprellten Taktvorgabesignals 27 ermitteln.

Das entprellte Taktvorgabesignal 27 gelangt von der Taktflankenentprellung 8 zu einer Logikeinheit 11. Die Logikeinheit 11 kann ein AND-Gatter, ein NAND-Gatter, ein OR-Gatter, ein NOR-Gatter, ein EXOR-Gatter, oder eine Kombination aus diesen Logik-Gattern aufweisen. Die Logikeinheit 11 kann als Torschaltung für die externe Triggerung ausgestaltet sein. Sie gibt in Abhängigkeit von einer Verknüpfung mit anderen Signalen oder der logischen Verknüpfung anderer Signale ein Synchronisationssignal 37 zu dem Synchronisationseingang 17.

Beispielsweise kann die Steuerung 2 mit dem von ihr generierten Taktfreigabesignal 15, das ebenfalls der Logikeinheit 11 zugeführt ist, ein Weiterleiten des entprellten Taktvorgabesignals 27 zum Synchronisationseingang 17 unterbinden oder zulassen. Die Steuerung 2 ermittelt beispielsweise die Frequenz des entprellten Taktvorgabesignals 27. Wenn die Steuerung 2 hier z.B. eine zu hohe Frequenz ermittelt, kann sie die Weiterleitung des entprellten Taktvorgabesignals 27 als das Synchronisationssignal 37 zu dem Synchronisationseingang 17 unterbinden. Wie im Folgenden noch beschrieben wird, kann die Steuerung 2 auch andere Signale ermitteln. Auch diese Signale kann die Steuerung 2 auswerten und auf Grund der Auswertung die Weiterleitung des entprellten Taktvorgabesignals 27 als das Synchronisationssignal 37 zu dem Synchronisationseingang 17 unterbinden oder zulassen. Das Synchronisationssignal 37 kann dann, wenn es zum Synchronisationseingang 17 gelangt, den Ring-Akkumulator 4 des Basistaktgenerators 1 zurücksetzen oder einen Roll-Over herbeiführen. Auf diese Art und Weise wird das Pulsfrequenzsignal 14 am Ausgang des Basistaktgenerators 1 als ein mit dem Taktvorgabesignal 7 synchronisiertes Basistaktsignal generiert. Das Ausgangssignal des Basistaktgenerators 1 wird der Übertaktungsschutzeinrichtung 5 zugeführt, durch die zu hohe Taktfrequenzen erkannt und gesperrt werden. Auf diese Art und Weise kann eine Schädigung eines Lasers verhindert werden. Am Taktsignalausgang 20 wird das Basistaktsignal ausgegeben. Das Basistaktsignal entspricht dem Pulsfrequenzsignal 14, wenn es in einem zulässigen Bereich liegt. Liegt das Pulsfrequenzsignal 14 nicht in einem zulässigen Frequenzbereich, wird ein Basistaktsignal mit einer Frequenz im zulässigen Frequenzbereich, z.B. einem höchstmöglichen ganzzahligen Teiler der Frequenz des Pulsfrequenzsignals am Taktsignalausgang 20 ausgegeben.

Durch eine zweite Messeinrichtung 22, die in der Steuereinheit 2 integriert sein kann, und die das Verhalten, insbesondere die Frequenz, des Pulsfrequenzsignals 14 am Ausgang des Basistaktgenerators 1 ermitteln kann, können zu schnelle Triggerungen erfasst werden.

Das am Ausgang des Basistaktgenerators 1 anliegende Pulsfrequenzsignal 14 wird auf eine Taktstabilisierungseinrichtung 9 rückgeführt. Der Taktstabilisierungseinrichtung 9 kann auch das entprellte Taktvorgabesignal 27 zugeführt werden. Die Taktstabilisierungseinrichtung 9 kann bei Fehl-Triggerungen die Folge schneller Clockeinrastungsvorgänge, insbesondere mit Hilfe eines binären Zählers, begrenzen. Hierzu kann das Taktstabilisierungsausgangssignal 18 der Taktstabilisierungseinrichtung 9 einem logischen Operator 10 zugeführt werden. Die Taktstabilisierungseinrichtung 9 kann einen binären Zähler, insbesondere einen 16-Bit-Zähler, aufweisen. Das entprellte Taktvorgabesignal 27 kann zum Zurücksetzen dieses Zählers dienen. Die Taktstabilisierungseinrichtung 9, insbesondere der Zähler, kann mit der Betriebsfrequenz des Taktsignalgenerators 21 betrieben werden. Das Pulsfrequenzsignal 14 kann als Signal zum Triggern des Zählers verwendet werden.

Der logische Operator 10 kann ein AND-Gatter, ein NAND-Gatter, ein OR-Gatter, ein NOR-Gatter, ein EXOR-Gatter, oder eine Kombination aus diesen Logik-Gattern aufweisen. Dem logischen Operator 10 kann ferner das Taktstabilisierungsfreigabesignal 16 von der Steuerung 2 zugeführt werden. Der Ausgang des logischen Operators 10 kann der Logikeinheit 11 zugeführt werden. So kann auch die Taktstabilisierungseinrichtung 9 ein Weiterleiten des entprellten Taktvorgabesignals 27 zum Synchronisationseingang 17 unterbinden oder zulassen. Auch die Steuerung 2 kann mit beeinflussen, ob das entprellte Taktvorgabesignals 27 zum Synchronisationseingang 17 unterbunden oder zugelassen wird.

Das Pulsfrequenzsignal 14 am Ausgang des Basistaktgenerators 1 wird weiterhin einer ersten Begrenzungseinrichtung 13 zugeführt. Die Begrenzungseinrichtung 13 kann einen binären Zähler, insbesondere einen 32-Bit-Zähler aufweisen. Das Pulsfrequenzsignal 14 kann zum Zurücksetzen dieses Zählers dienen. Das Pulsfrequenzsignal 14 kann auch als Signal zum Triggern des Zählers verwendet werden.

Die Begrenzungseinrichtung 13, insbesondere der Zähler, kann mit der Betriebsfrequenz des Taktsignalgenerators 21 betrieben werden. Die Begrenzungseinrichtung 13 dient zur Unterdrückung von Taktvorgabesignalen 7 mit einer Frequenz über einer vorgegebenen Frequenz. Der Ausgang der ersten Begrenzungseinrichtung 13 ist wiederum der Logikeinheit 11 zugeführt. So kann auch die Begrenzungseinrichtung 13 ein Weiterleiten des entprellten Taktvorgabesignals 27 zum Synchronisationseingang 17 unterbinden oder zulassen.

Das Pulsfrequenzsignal 14 am Ausgang des Basistaktgenerators 1 wird weiterhin einer Überwachungseinrichtung 12 zugeführt. Die Überwachungseinrichtung 12 kann als State-Maschine ausgebildet sein, und so eine Überwachung hinsichtlich des Vorliegens eines Taktvorgabesignals 7, eines entprellten Taktvorgabesignals 27 oder, insbesondere des Synchronisationssignal 37 durchführen. Dazu kann der Überwachungseinrichtung 12 insbesondere das Synchronisationssignal 37 zugeführt werden. Die Überwachungseinrichtung 12 kann einen binären Zähler, insbesondere einen 2-Bit-Zähler aufweisen. Das Synchronisationssignal 37 kann zum Zurücksetzen dieses Zählers dienen. Das Pulsfrequenzsignal 14 kann als Signal zum Triggern des Zählers verwendet werden. Die Überwachungseinrichtung 12, insbesondere der Zähler, kann mit der Betriebsfrequenz des Taktsignalgenerators 21 betrieben werden. Die Überwachungseinrichtung 12 steht mit einer zweiten Begrenzungseinrichtung 6 in Verbindung, insbesondere wird ihr Ausgangssignal der zweiten Begrenzungseinrichtung 6 zugeführt. Dadurch ist es möglich, Taktvorgabesignale 7 mit einer Frequenz unter einer vorgegebenen zweiten Frequenz zu unterdrücken. Zu diesem Zweck steht die zweite Begrenzungseinrichtung 6 mit dem Basistaktgenerator 1 in Verbindung. Insbesondere kann der Ausgang der Begrenzungseinrichtung 6 mit dem Addierglied 24 des Basistaktgenerators 1 verbunden sein. Dadurch kann eine Frequenzerhöhung des Basistakts, also des Pulsfrequenzsignals 14, bei erfolgreicher externer Taktvorgabe erfolgen.

Das Ausgangssignal der Überwachungseinrichtung 12 kann durch eine Erfassungseinrichtung 23, die in der Steuereinheit 2 integriert sein kann, erfasst werden. Über das erfasste Signal der Erfassungseinrichtung 23 kann die Steuereinheit 2 erkennen, ob mit dem Signal am Synchronisationseingang 17 synchronisiert wurde oder nicht.

Durch die Steuereinheit 2 kann somit eine erneute Synchronisation freigegeben werden, wenn erkannt wird, dass eine Synchronisation mit dem Taktvorgabesignal erfolgt ist. Durch die Steuereinheit 2 kann somit auch eine erneute Synchronisation unterbunden werden, wenn erkannt wird, dass eine Synchronisation mit dem Taktvorgabesignal nicht erfolgt ist. Zu diesem Zweck ist die Steuereinheit 2 mit der Logikeinheit 11 verbunden.

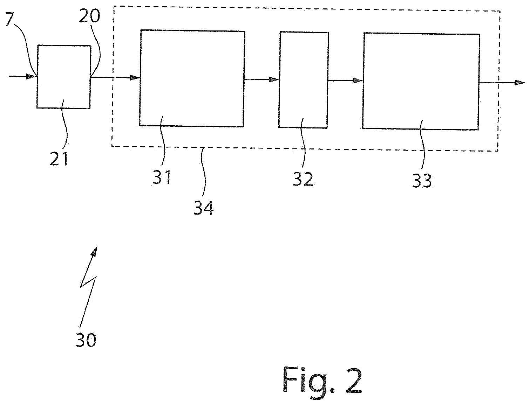

In Fig. 2 ist ein Lasersystem 30 gezeigt, das einen zuvor beschriebenen Laser-Taktsignalgenerator 21 aufweist. Der Taktsignalausgang 20 kann mit einem Pulsgenerator 31 verbunden sein, so dass das Taktsignal dem Pulsgenerator 31 zugeführt werden kann. Der Pulsgenerator 31 ist eingerichtet, im Takt des Taktsignals ein Signal mit vorgegebener Leistung zur Ansteuerung einer Laseranregungseinheit 32 zu erzeugen. Die Laseranregungseinheit 32 kann selbst eine Laserdiode sein. Der Ausgang des Pulsgenerators 31 kann mit einer Laseranregungseinheit 32, insbesondere einer Laserdiode, verbunden sein, so wie in Fig. 2 gezeigt. Der von der Laserdiode erzeugte Laserpuls kann einem optischen Verstärker 33 (gepumpter Faserverstärker, Cavity-Dumped oder regeneratives Verstärkersystem etc.) zugeführt werden, so wie in Fig. 2 gezeigt. Der optische Verstärker 33 kann einen Laserpuls zur Bearbeitung von Werkstücken oder anderen thermischen oder optischen Prozessen erzeugen, dessen optische Leistung um ein Vielfaches größer ist als die Leistung der Laseranregungseinheit 32. Wie bereits beschrieben, ist es wichtig, dass das System ausfallsicher läuft. Es darf deshalb nur innerhalb bestimmter Frequenzbereiche betrieben werden. Pulsgenerator 31, Laseranregungseinheit 32 und optischer Verstärker 33 stellen einen Laserstrahlerzeuger 34 dar.

## Patentansprüche

1. Laser-Taktsignalgenerator (21) zur Ansteuerung eines Laserstrahlerzeugers für die Erzeugung gepulster Laserstrahlung mit einem dem Laserstrahlerzeuger zuführbaren Taktsignalausgang (20) und einem Basistaktgenerator (1), der ein am Taktsignalausgang (20) ausgebbares Basistaktsignal generiert, einem Taktvorgabesignaleingang (7) zum Anschluss eines externen Taktvorgabesignals, wobei eine Steuereinheit (2) vorgesehen ist, die den Basistaktgenerator (1) ansteuert, und mit einer zwischen dem Basistaktgenerator (1) und dem Taktsignalausgang (20) angeordneten Übertaktungsschutzeinrichtung (5).

2. Taktsignalgenerator nach Anspruch 1, **dadurch gekennzeichnet, dass** der Basistaktgenerator (1) einen Ring-Akkumulator (4) und ein diesem zugeordnetes Frequenzregister (3) aufweist.

3. Taktsignalgenerator nach einem der vorhergehenden Ansprüche, **dadurch gekennzeichnet, dass** der Basistaktgenerator (1) einen Synchronisationseingang (17) zur Synchronisierung mit dem Taktvorgabesignal aufweist.

4. Taktsignalgenerator nach einem der vorhergehenden Ansprüche, **dadurch gekennzeichnet, dass** eine von der Steuereinheit (2) ansteuerbare Logikeinheit (11) zwischen Taktvorgabesignaleingang (7) und Basistaktgenerator (1), insbesondere dem Synchronisationseingang (17), vorgesehen ist.

5. Taktsignalgenerator nach einem der vorhergehenden Ansprüche, **dadurch gekennzeichnet, dass** eine Messeinrichtung (19) zur Erfassung der Frequenz des Taktvorgabesignals vorgesehen ist.

6. Taktsignalgenerator nach einem der vorhergehenden Ansprüche, **dadurch gekennzeichnet, dass** eine erste Begrenzungseinrichtung (13) zur Unterdrückung von Taktvorgabesignalen mit einer Frequenz über einer vorgegebenen Frequenz vorgesehen ist.

7. Taktsignalgenerator nach einem der vorhergehenden Ansprüche, **dadurch gekennzeichnet, dass** eine zweite Begrenzungseinrichtung (6) zur Unterdrückung von Taktvorgabesignalen mit einer Frequenz unter einer vorgegebenen zweiten Frequenz vorgesehen ist.

8. Taktsignalgenerator nach Anspruch 7, **dadurch gekennzeichnet, dass** die zweite Begrenzungseinrichtung (6) mit dem Basistaktgenerator (1) zur bedarfsweisen Reduzierung des Basistakts verbunden ist.

9. Taktsignalgenerator nach einem der vorhergehenden Ansprüche, **dadurch gekennzeichnet, dass** eine Taktstabilisierungseinrichtung (9) vorgesehen ist.

10. Taktsignalgenerator nach einem der vorhergehenden Ansprüche, **dadurch gekennzeichnet, dass** eine Überwachungseinrichtung (12) zur Überwachung hinsichtlich des Vorliegens eines Taktvorgabesignals vorgesehen ist.

11. Taktsignalgenerator nach einem der vorhergehenden Ansprüche, **dadurch gekennzeichnet, dass** eine Überwachungseinrichtung zur Überwachung der Synchronisation des Basistaktgenerators auf das Taktvorgabesignal vorgesehen ist.

12. Taktsignalgenerator nach einem der vorhergehenden Ansprüche, **dadurch gekennzeichnet, dass** eine Taktflankenentprellung (8) vorgesehen ist.

13. Lasersystem (30) aufweisend einen Laser-Taktsignalgenerator (21) nach einem der vorhergehenden Ansprüche und
• einen Pulsgenerator (31),
• eine Laseranregungseinheit (32) und/oder
• einen optischen Verstärker (33).

14. Verwendung eines Laser-Taktsignalgenerators (21) oder Lasersystems (30) nach einem der vorhergehenden Ansprüche - zur Ansteuerung eines Laserstrahlerzeugers für die Erzeugung gepulster Laserstrahlung und, insbesondere zum Anschluss eines externen Taktvorgabesignals an den Taktvorgabesignaleingang (7).

15. Verwendung eines Lasersystems (30) nach Anspruch 13 mit einer Laseranregungseinheit (32) und einem optischen Verstärker (33) zur Erzeugung eines Laserpulses am Ausgang des optischen Verstärkers (33) zur Bearbeitung von Werkstücken oder anderen thermischen oder optischen Prozessen, wobei die optische Leistung am Ausgang des optischen Verstärkers (33) um ein Vielfaches größer ist als die Leistung der Laseranregungseinheit (32).

## Claims

1. Laser clock signal generator (21) for controlling a laser beam generator for generating pulsed laser radiation with a clock signal output (20) which can be supplied to the laser beam generator and a basic clock generator (1) which generates a basic clock signal which can be output at the clock signal output (20), a clock signal specification input (7) for connecting an external clock specification signal, wherein there is provided a control unit (2) which controls the basic clock generator (1), and having an overclocking protection device (5) which is arranged between the basic clock generator (1) and the clock signal output (20).

2. Clock signal generator according to claim 1, **characterised in that** the basic clock generator (1) has a ring accumulator (4) and a frequency register (3) which is associated therewith.

3. Clock signal generator according to either of the preceding claims, **characterised in that** the basic clock generator (1) has a synchronisation input (17) for synchronisation with the clock specification signal.

4. Clock signal generator according to any one of the preceding claims, **characterised in that** a logic unit (11) which can be controlled by the control unit (2) is provided between the clock specification signal input (7) and the basic clock generator (1), in particular the synchronisation input (17).

5. Clock signal generator according to any one of the preceding claims, **characterised in that** a measurement device (19) for detecting the frequency of the clock specification signal is provided.

6. Clock signal generator according to any one of the preceding claims, **characterised in that** a first limitation device (13) for suppressing clock specification signals at a frequency over a predetermined frequency is provided.

7. Clock signal generator according to any one of the preceding claims, **characterised in that** a second limitation device (6) for suppressing clock specification signals at a frequency below a predetermined second frequency is provided.

8. Clock signal generator according to claim 7, **characterised in that** the second limitation device (6) is connected to the basic clock generator (1) in order to reduce the basic clock as required.

9. Clock signal generator according to any one of the preceding claims, **characterised in that** a clock stabilisation device (9) is provided.

10. Clock signal generator according to any one of the preceding claims, **characterised in that** a monitoring device (12) for monitoring with regard to the presence of a clock specification signal is provided.

11. Clock signal generator according to any one of the preceding claims, **characterised in that** a monitoring device for monitoring the synchronisation of the basic clock generator to the clock specification signal is provided.

12. Clock signal generator according to any one of the preceding claims, **characterised in that** a clock flank debouncing (8) is provided.

13. Laser system (30) having a laser clock signal generator (21) according to any one of the preceding claims, and
• a pulse generator (31),
• a laser excitation unit (32) and/or
• an optical amplifier (33).

14. Use of a laser clock signal generator (21) or laser system (30) according to any one of the preceding claims - for controlling a laser beam generator for generating pulsed laser radiation and in particular for connecting an external clock specification signal to the clock specification signal input (7).

15. Use of a laser system (30) according to claim 13 with a laser excitation unit (32) and an optical amplifier (33) for producing a laser pulse at the output of the optical amplifier (33) for processing workpieces or other thermal or optical processes, wherein the optical power at the output of the optical amplifier (33) is many times greater than the power of the laser excitation unit (32).

## Revendications

1. Générateur de signal d'horloge laser (21) pour commander un générateur de faisceau laser destiné à générer un rayonnement laser pulsé, avec une sortie de signal d'horloge (20) pouvant être amenée au générateur de faisceau laser et un générateur d'horloge de base (1) qui génère un signal d'horloge de base qui peut être fourni à la sortie de signal d'horloge (20), une entrée de signal de consigne d'horloge (7) destinée à être connectée à un signal de consigne d'horloge externe, une unité de commande (2) étant prévue, qui commande le générateur d'horloge de base (1), et avec un dispositif de protection contre le dépassement de fréquence d'horloge (5) disposé entre le générateur d'horloge de base (1) et la sortie de signal d'horloge (20).

2. Générateur de signal d'horloge selon la revendication 1, **caractérisé en ce que** le générateur d'horloge de base (1) présente un accumulateur en anneau (4) et un registre de fréquence (3) associé à ce dernier.

3. Générateur de signal d'horloge selon l'une des revendications précédentes, **caractérisé en ce que** le générateur d'horloge de base (1) présente une entrée de synchronisation (17) pour la synchronisation avec le signal de consigne d'horloge.

4. Générateur de signal d'horloge selon l'une des revendications précédentes, **caractérisé en ce qu'**une unité logique (11) pouvant être commandée par l'unité de commande (2) est prévue entre l'entrée de signal de consigne d'horloge (7) et le générateur d'horloge de base (1), en particulier l'entrée de synchronisation (17).

5. Générateur de signal d'horloge selon l'une des revendications précédentes, **caractérisé en ce qu'**un dispositif de mesure (19) est prévu pour détecter la fréquence du signal de consigne d'horloge.

6. Générateur de signal d'horloge selon l'une des revendications précédentes, **caractérisé en ce qu'**un premier dispositif de limitation (13) est prévu pour supprimer les signaux de consigne d'horloge dont la fréquence est supérieure à une fréquence prédéfinie.

7. Générateur de signal d'horloge selon l'une des revendications précédentes, **caractérisé en ce qu'**un deuxième dispositif de limitation (6) est prévu pour supprimer les signaux de consigne d'horloge dont la fréquence est inférieure à une deuxième fréquence prédéfinie.

8. Générateur de signal d'horloge selon la revendication 7, **caractérisé en ce que** le deuxième dispositif de limitation (6) est relié au générateur d'horloge de base (1) pour réduire l'horloge de base en cas de besoin.

9. Générateur de signal d'horloge selon l'une des revendications précédentes, **caractérisé en ce qu'**un dispositif de stabilisation d'horloge (9) est prévu.

10. Générateur de signal d'horloge selon l'une des revendications précédentes, **caractérisé en ce qu'**un dispositif de surveillance (12) est prévu pour surveiller la présence d'un signal de consigne d'horloge.

11. Générateur de signal d'horloge selon l'une des revendications précédentes, **caractérisé en ce qu'**un dispositif de surveillance est prévu pour surveiller la synchronisation du générateur d'horloge de base avec le signal de consigne d'horloge.

12. Générateur de signal d'horloge selon l'une des revendications précédentes, **caractérisé en ce qu'**un dispositif anti-rebondissement de front d'horloge (8) est prévu.

13. Système laser (30) présentant un générateur de signal d'horloge laser (21) selon l'une des revendications précédentes et
• un générateur d'impulsions (31),
• une unité d'excitation laser (32) et/ou
• un amplificateur optique (33).

14. Utilisation d'un générateur de signal d'horloge laser (21) ou d'un système laser (30) selon l'une des revendications précédentes pour la commande d'un générateur de faisceau laser destiné à générer un rayonnement laser pulsé et, en particulier, pour la connexion d'un signal de consigne d'horloge externe à l'entrée de signal de consigne d'horloge (7).

15. Utilisation d'un système laser (30) selon la revendication 13 avec une unité d'excitation laser (32) et un amplificateur optique (33) pour générer une impulsion laser à la sortie de l'amplificateur optique (33) pour l'usinage de pièces ou d'autres processus thermiques ou optiques, la puissance optique à la sortie de l'amplificateur optique (33) étant plusieurs fois supérieure à la puissance de l'unité d'excitation laser (32).
